(19) Europäisches Patentamt
European Patent Office
Office européen des brevets

(11) Veröffentlichungsnummer: **0 414 100 A2**

(12) **EUROPÄISCHE PATENTANMELDUNG**

(21) Anmeldenummer: **90115563.0**

(22) Anmeldetag: **14.08.90**

(51) Int. Cl.5: **G03F 7/032**, G03F 7/039, C08F 299/06, G03F 7/027

(30) Priorität: **22.08.89 DE 3927629**

(43) Veröffentlichungstag der Anmeldung: **27.02.91 Patentblatt 91/09**

(84) Benannte Vertragsstaaten: **AT BE CH DE DK ES FR GB IT LI NL SE**

(71) Anmelder: **BASF Aktiengesellschaft**
**Carl-Bosch-Strasse 38**
**D-6700 Ludwigshafen(DE)**

(72) Erfinder: **Seitz, Friedrich, Dr.**
**Von-Wieser-Strasse 1**
**D-6701 Friedelsheim(DE)**
Erfinder: **Beck, Erich, Dr.**
**Konrad-Adenauer-Strasse 15**
**D-6721 Harthausen(DE)**
Erfinder: **Roser, Joachim, Dr.**
**Saarlandstrasse 40**
**D-6700 Ludwigshafen(DE)**
Erfinder: **Bueschges, Eleonore, Dr.**
**Schauinslandstrasse 9**
**D-6800 Mannheim 1(DE)**
Erfinder: **Schulz, Guenther, Dr.**
**Im Roehrich 45**
**D-6702 Bad Duerkheim(DE)**
Erfinder: **Zwez, Thomas, Dr.**
**Allmendstrasse 8**
**D-7500 Karlsruhe 51(DE)**

# (54) Strahlungsempfindliches, positiv arbeitendes Gemisch.

(57) Die Erfindung betrifft ein strahlungsempfindliches, positiv arbeitendes Gemisch, das besteht aus

(a) einem Harnstoff- und Urethangruppen enthaltenden ethylenisch ungesättigten Umsetzungsprodukt,
(b) mindestens einer eine oder mehrere Carboxylgruppen enthaltenden organischen Verbindung,
(c) gegebenenfalls einem Photoinititator oder Photoinitiatorsystem
sowie
(d) gegebenenfalls weiteren Zusatz- und Hilfsstoffen.

EP 0 414 100 A2

# STRAHLUNGSEMPFINDLICHES, POSITIV ARBEITENDES GEMISCH

Die Erfindung betrifft strahlungsempfindliche, positiv arbeitende Gemische, deren Löslichkeit in Wasser oder wäßrig-alikalischen Lösungen bei Bestrahlung zunimmt.

Positiv arbeitende lichtempfindliche Zusammensetzungen, d.h. Verbindungen oder Gemische von Verbindungen, deren Löslichkeit in einem vorgegebenen Lösungsmittel bei Bestrahlung zunimmt, sind an sich bekannt. Die in der Reproduktionstechnik am häufigsten eingesetzten Verbindungen sind Naphthochinondiazide oder deren Derivate (vgl. W. Fraß, Chemie in unserer Zeit, 17 (1983) 10; H. W. Vollmann, Angew. Chem. 92 (1980) 95). Bei Bestrahlung dieser Verbindungen wird über Stickstoffabspaltung und Wolff-Umlagerung aus einer hydrophoben Diazoketon-Einheit eine Carboxylgruppe gebildet, die die genannten Verbindungen bzw. die aus diesen Verbindungen hergestellten Mischungen in wäßrig-alkalischen Lösungen löslich macht.

Eine weitere Verbindungsklasse, die sich zur Herstellung von positiv arbeitenden lichtempfindlichen Gemischen eignet, sind aromatische oder heteroaromatische Nitroverbindungen. Während die oben beschriebenen Verbindungen mit Diazoketon-Struktur in den lichtempfindlichen Gemischen meist als niedermolekulare Verbindungen vorliegen, können als lichtempfindliche Nitroverbindungen sowohl niedermolekulare Verbindungen (DE-A-22 07 574, US-A-4 181 531) als auch Polymere aus Monomeren mit o-Nitrocarbinolester-Struktur bzw. Copolymere dieser Monomeren mit anderen Vinylverbindungen verwendet werden (vgl. DE-A-21 50 691, DE-A-29 22 746 und EP-A-19 770). Auch hier wird bei Bestrahlung eine Carboxylgruppe gebildet, die die Löslichkeit der Gemische in wäßrig-alkalischen Lösungen erhöht.

Auf einem ähnlichen Prinzip dürften die Positivsysteme beruhen, die z. B. in US-A-4 469 774 beschrieben sind und photochemisch spaltbare Benzoinester in der Seitenkette enthalten.

Ein weiteres Verfahren, das auf der Erhöhung der Löslichkeit durch Carboxylgruppen beruht, ist zum Beispiel in EP-A-62 474, EP-A-99 949 oder US-A-4 415 652 beschrieben. Hier wird ein Gemisch aus einem in wäßriger Lösung unlöslichen Bindemittel, einer Mercaptocarbonsäure und einem bei Bestrahlung Radikale bildenden Initiatorsystem beschrieben. Die Bestrahlung führt zu einer radikalischen Pfropfung der Mercaptocarbonsäure auf das Bindemittel, das dadurch in wäßrig-alkalischen Lösungen löslich wird.

Bei photoempfindlichen Mischungen,, die nach einem der oben beschriebenen Prinzipien aufgebaut sind, wird pro absorbiertem Lichtquant nur maximal eine Carboxylgruppe erzeugt bzw. auf das Bindemittel gepfropft. Meist liegt die Quantenausbeute noch deutlich unter 1. Daher sind in allen Fällen lange Belichtungszeiten erforderlich, die erreichte Löslichkeitsdifferenzierung ist dennoch meist schlecht. Von den genannten photoempfindlichen Systemen konnten sich daher nur die auf der Basis der Wolff-Umlagerung von Diazoketonen funktionierenden auf dem Markt behaupten, und auch diese nur im Bereich der Positiv-Offset-Platten bzw. der Positivresiste für die Herstellung integrierter Schaltungen. Für andere Produkte, von denen insbesondere Photoresistfilme für die Leiterplattenfertigung genannt seien, sind die erforderlichen langen Belichtungszeiten und die wegen der geringen Löslichkeitsdifferenzierung erforderlichen halbwäßrigen Entwicklerlösungen unakzeptabel. Das Problem der Entsorgung der Entwicklerlösungen wird in Zukunft noch an Bedeutung gewinnen.

Eine prinzipiell andere Möglichkeit, die Löslichkeit einer photoempfindlichen Schicht durch Belichtung zu erhöhen, besteht darin, die Zusammensetzung der Schicht so zu wählen, daß bei Bestrahlung das mittlere Molekulargewicht des Bindemittels abnimmt. Hierzu werden durch aktinisches Licht spaltbare Gruppen in die Hauptkette eines Polymeren eingebaut. Beispiele für solche Systeme sind z. B. Polyoxymethylen-Polymere, die in der Hauptkette Acetaleinheiten, die aus o-Nitrobenzaldehyd oder Derivaten des o-Nitrobenzaldehyds gebildet sind, enthalten. Solche Polymere und aus ihnen hergestellte lichtempfindliche Schichten sind z. B. in US-A-3 991 033 und US-A-4 189 611 beschrieben. Auf ähnliche Weise können Acetale des o-Nitrobenzaldehyds auch in die Hauptkette von Polymeren eingebaut werden, die im wesentlichen einen Polyester aus einer Dicarbonsäure und einem difunktionellen Alkohol darstellen (vgl. US-A-4 086 210). Andere Polymere, die bei Bestrahlung unter Spaltung der Hauptkette und damit einer Verringerung des Molekulargewichts reagieren, sind Polymere, die in ihrer Hauptkette Hexaarylbisimidazoleinheiten enthalten (vgl. US-A-4 009 040).

Als eine Kombination aus Hauptkettenabbau und Pfropfung einer Carboxylgruppe läßt sich das in EP-A-57 162 beschriebene Verfahren verstehen, in dem neben einem Polymeren, das in der Hauptkette Benzoineinheiten enthält, ungesättigte Carbonsäuren vorliegen. Bei Belichtung werden die Benzoineinheiten unter Verringerung des mittleren Molekulargewichts gespalten. Gleichzeitig werden die ungesättigten Carbonsäuren an die an den Spaltstellen entstehenden Radikale addiert und erhöhen so ebenfalls die Löslichkeit in wäßrig-alkalischer Lösung.

Auch die auf dem Hauptkettenabbau eines geeigneten Polymeren nach einem der oben beschriebenen Prinzipien basierenden positiv arbeitenden photoempfindlichen Schichten weisen nur eine geringe Lichtempfindlichkeit auf. Zudem ist in vielen Fällen nach der Belichtung eine thermische Nachbehandlung nötig. In der Praxis konnte sich daher keines der beschriebenen Verfahren durchsetzen.

Man hat daher versucht, die hohe Lichtempfindlichkeit photopolymerisierbarer Schichten für die Herstellung positiv arbeitender Schichten zu nutzen, indem man durch Belichtung durch eine Vorlage bildmäßig einen Inhibitor der Polymerisation erzeugt und dann in einem zweiten, nicht notwendigerweise bildmäßigen Belichtungsschritt die nicht inhibierten Stellen polymerisiert. Als Verbindungen, aus denen durch Belichtung Polymerisationsinhibitoren erzeugt werden können, wurden z. B. Nitrosodimere (vgl. DE-A-25 42 151) oder gewisse o-Nitroaromaten vorgeschlagen (vgl. DE-A-27 10 417 und EP-A-103 197). Bei diesen Verfahren ist in jedem Fall ein zusätzlicher Belichtungsschritt nötig, so daß die Gesamtprozeßzeit gegenüber anderen Positivsystemen eher erhöht wird.

Der bisher erfolgreichste Versuch, die Lichtempfindlichkeit positiv arbeitender lichtempfindlicher Schichten zu erhöhen, ist unter dem Begriff der chemischen Verstärkung bekannt geworden. Hier wird bei Belichtung ein Katalysator erzeugt, der in einem zweiten, thermischen Verfahrensschritt eine Reaktion beschleunigt, die letztlich zu einer Erhöhung der Löslichkeit der photoempfindlichen Schicht führt. Bei dem Katalysator handelt es sich meist um eine starke Säure, die photochemisch z. B. aus einer organischen Halogenverbindung, vor allem einer halogenhaltigen Triazinverbindung (vgl. z. B. DE-A-23 06 248), einer aromatischen Nitroverbindung (vgl. z. B. EP-A-78 981), einem Diazoniumsalz oder einem aromatischen Iodonium- bzw. Sulfoniumsalz (vgl. z. B. DE-A-36 20 677 und US-A-4 491 628) gebildet wird. Die gebildete Säure wird benutzt, um im zweiten, thermischen Verfahrensschritt säurelabile Bindungen zu spalten. Je nach verwendeter säurelabiler Verbindung kann diese Spaltung entweder die Bildung einer hydrophilen aus einer hydrophoben Gruppe (vgl. z. B. DE-A-36 20 677 und US-A-4 491 628) oder einen Abbau des Molekulargewichts bewirken. Für den letzten Fall geeignete säurelabile Gruppen sind z. B. Acetal- (vgl. DE-A-23 06 248, EP-A-78 981, EP-A-82 463 und US-A-3 779 778), Orthocarbonsäureester- (vgl. EP-A-78 981 und EP-A-82 463), Enolether- (vgl. EP-A-6 627 und EP-A-82 463), Silylether-(vgl. DE-A-35 44 165 und EP-A-130 599) oder Silylestergruppen (vgl. EP-A-130 599). Obwohl mit diesen Gemischen Lichtempfindlichkeiten erreicht werden können, die in günstigen Fällen denen negativ arbeitender Schichten entsprechen, haben Produkte, die nach dem Prinzip der chemischen Ver stärkung aufgebaut sind, nur im Bereich der Resiste für die Herstellung integrierter Schaltungen Bedeutung erlangt. In anderen Einsatzgebieten wird der erforderliche zusätzliche thermische Verfahrensschritt nicht akzeptiert.

Ein weiterer Typ eines positiv arbeitenden lichtempfindlichen Gemisches wird in EP-A-106 156 beschrieben. Dieses Gemisch besteht aus einem Polykondensat mit bestimmten Gruppen in der Hauptkette und ungesättigten Gruppen am Kettenende in Kombination mit einem Photoinitiator. Als die Hauptkette aufbauende Gruppen werden aromatische Kohlenwasserstoff-, Diarylether-, Diarylsulfid-, Diarylsulfon-, Diarylamin-, Diarylketon- und Diaryldiketongruppen genannt. Endgruppen sind Alkenylgruppen oder Reste ungesättigter Carbonsäuren. Als Ursache für die Erhöhung der Löslichkeit bei Belichtung wird ein radikalisch induzierter Kettenabbau vermutet. Trotz eines sehr hohen Initiatoranteils von typischerweise 25 Gew.% werden nur mäßige Lichtempfindlichkeiten erreicht.

Die Verwendung bestimmter Vinylgruppen enthaltender Urethanverbindungen als Rohstoffe in photoempfindlichen Zusammensetzungen ist an sich bekannt (vgl. EP-A-48 913, EP-A-54 150 und EP-A-72 918). Dabei handelt es sich jedoch stets um Systeme, deren Löslichkeit nach Belichtung abnimmt, also um negativ arbeitende Systeme.

Die aufgeführten Beispiele zeigen, daß für die meisten Anwendungszwecke noch immer ein Bedarf an neuen positiv arbeitenden lichtempfindlichen Gemischen besteht, die hohe Lichtempfindlichkeit und einfache Handhabung, d. h. insbesondere keine zusätzlichen Verfahrensschritte, miteinander kombinieren. Aufgabe der vorliegenden Erfindung war es, ein positiv arbeitendes lichtempfindliches Gemisch mit den genannten Eigenschaften zu entwickeln sowie das ihm zugrundeliegende Umsetzungsprodukt aufzuzeigen.

Überraschenderweise wurde gefunden, daß die Löslichkeit von Gemischen aus bestimmten ethylenisch ungesättigten Harnstoff- und Urethangruppen enthaltenden Umsetzungsprodukten mit Verbindungen, die eine oder mehrere Carboxylgruppen enthalten, bei Belichtung in Gegenwart von Verbindungen, aus denen bei Belichtung Radikale entstehen, zunimmt.

Gegenstand der vorliegenden Erfindung ist ein strahlungsempfindliches, positiv arbeitendes Gemisch, das dadurch gekennzeichnet ist, daß es besteht aus

(a) einem Harnstoff- und Urethangruppen enthaltenden ethylenisch ungesättigten Umsetzungsprodukt,

(b) mindestens einer eine oder mehrere Carboxylgruppen enthaltenden organischen Verbindung,

(c) gegebenenfalls einem Photoinitiator oder Photoinitiatorsystem

sowie

(d) gegebenenfalls weiteren Zusatz- und Hilfsstoffen, wobei als Komponente (a) ein Harnstoff- und Urethangruppen enthaltendes ethylenisch ungesättigtes Umsetzungsprodukt eingesetzt wird, das durch Umsetzung von

i) mindestens einem ein- oder mehrfach ethylenisch ungesättigten Mono- oder Polyalkohol mit

ii) mindestens einem Di- oder Polyisocyanat und

iii)mindestens einer Aminoverbindung mit primärer und/oder sekundärer Aminogruppe,

sowie gegebenenfalls

iv) mindestens einer von Komponente i) verschiedenen organischen Verbindung mit mindestens einer Hydroxylgruppe, wobei die Anzahl der NCO-Gruppen in Komponente ii) kleiner oder gleich der Anzahl der damit reaktiven Gruppen in Komponente i), iii) und iv) ist, erhalten worden ist.

Besondere Ausführungsformen der Erfindung bestehen darin, daß man zur Herstellung der Komponente (a) als Komponente i) einen einfach ethylenisch ungesättigten Mono- oder Polyalkohol, einen ein- oder mehrfach ethylenisch ungesättigten Monoalkohol, einen einfach ethylenisch ungesättigten Monoalkohol, eine eine Hydroxylgruppe enthaltende $\alpha,\beta$-ethylenisch ungesättigte Carbonylverbindung, insbesondere ein Monohydroxyalkylacrylat oder -methacrylat, als Komponente ii) ein Diisocyanat und als Komponente iii) ein oder mehrere primäre und/oder sekundäre Amine verwendet. Als Komponente (a) bevorzugt ist ferner ein Umsetzungsprodukt, zu dessen Her stellung als Komponente iii) mindestens eine Aminoverbindung der allgemeinen Formel

$R'HN-R-XH$,

wobei

R den zweiwertigen Rest eines, gegebenenfalls substituierten, Alkans, Arens, Ethers, Polyethers, Amins, Polyamins, Esters, Polyesters, Amids oder Polyamids,

$R'$ Wasserstoff, Alkyl, Aryl, Aralkyl, Hydroxyalkyl, Aminoalkyl, Mercaptoalkyl, Derivate derselben oder den einwertigen Rest $H\{O-(CH_2)_nCHR''\}_m$ mit $n$ = 1 bis 3 und $m$ = 1 bis 10 oder Isomere desselben und $R''$ = H oder $C_1$- bis $C_4$-Alkyl

X O, S oder $NR'''$,

$R'''$ Wasserstoff, Alkyl, Aryl, Aralkyl, Hydroxyalkyl, Aminoalkyl, Mercaptoalkyl oder Derivate derselben bedeuten, und/oder

mindestens einer Aminoverbindung der allgemeinen Formel

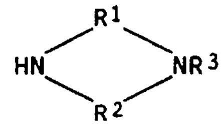,

wobei

$R^1$ und $R^2$ untereinander gleich oder verschieden sind und den zweiwertigen Rest eines, gegebenenfalls substituierten, Alkans, Arens, Ethers, Polyethers, Amins, Polyamins, Esters, Polyesters, Amids oder Polyamids bedeuten,

$R^3$ Wasserstoff, Alkyl, Aryl, Aralkyl, Hydroxyalkyl, Aminoalkyl, Mercaptoalkyl oder Derivate derselben bedeutet.

Als Komponente (b) kommen vorzugsweise Carboxylgruppen enthaltende organische Verbindungen mit einem mittleren Molekulargewicht $\overline{M}_n$ von mehr als 10.000, insbesondere von 15.000 bis 300.000, bevorzugt solche mit einer Säurezahl zwischen 50 und 300, insbesondere Copolymere aus einem sauren Monomeren und mindestens einem hydrophoben Monomeren in Betracht, wobei als saure Monomere Acrylsäure, Methacrylsäure, Crotonsäure und/oder Itaconsäure und als hydrophobe Monomere solche aus der Gruppe der Styrole, Acrylate und Methacrylate bevorzugt sind.

Als Photoinitiator oder Photoinitiatorsysteme (c) enthalten die erfindungsgemäßen strahlungsempfindlichen Gemische bevorzugt Benzophenon oder seine Derivate, Hexaarylbisimidazolderivate, N-Alkoxypyridiniumsalze oder Gemische dieser Verbindungen.

Insbesondere sind solche strahlungsempfindlichen Gemische Gegenstand der Erfindung, deren Löslichkeit in Wasser oder wäßrig-alkalischer Lösung bei Bestrahlung oder Belichtung zunimmt.

Das erfindungsgemäß einzusetzende Harnstoffgruppen enthaltende Umsetzungsprodukt (a) wird also durch Umsetzung der Isocyanat-Komponente (ii) mit der ungesättigten Alkohol-Komponente (i) und gleichzeitig oder stufenweise mit der Amin-Komponente (iii) sowie gegebenenfalls einer Hydroxylverbindung iv) zu einer ungesättigten Urethan-Harnstoffverbindung hergestellt, wobei die gegenüber Isocyanat reaktiven Gruppen, bevorzugt im Überschuß, insbesondere in Verhältnissen zwischen 1,5 : 1 und 4 : 1, eingesetzt werden.

Diese Reaktion kann lösungsmittelfrei oder auch in inerten Lösungsmitteln, z. B. Aceton, Tetrahydrofuran, Dioxan, Dichlormethan, Toluol, Methylethylketon und/oder Essigester, durchgeführt werden. Ebenfalls als Lösungsmittel geeignet sind ein- oder mehrfach ethylenisch ungesättigte Verbindungen, sofern diese flüssig sind.

Die Reaktionstemperatur für die Umsetzung der Isocyanatgruppen liegt im allgemeinen zwischen 0 und 100 °C, vorzugsweise zwischen 20

und 70° C.

Zur Beschleunigung der Umsetzung können Katalysatoren wie sie z. B. in Houben Weyl, Methoden der organischen Chemie, Bd. XIV/2, S. 60f, Georg Thieme-Verlag, Stuttgart (1963) bzw. Ullmann, Encyclopädie der technischen Chemie, Bd. 19, S. 306 (1981) beschrieben sind, eingesetzt werden. Bevorzugt sind zinnhaltige Verbindungen wie Dibutylzinndilaurat, Zinn(II)octoat oder Dibutylzinndimethoxid.

Im allgemeinen wird der Katalysator in einer Menge von 0,001 bis 2,5 Gew.%, bevorzugt von 0,005 bis 1,5 Gew.%, bezogen auf die Gesamtmenge der Reaktanden eingesetzt.

Zur Stabilisierung werden im allgemeinen 0,001 bis 2 Gew.%, vorzugsweise 0,005 bis 1,0 % Polymerisationsinhibitoren zugesetzt. Dabei handelt es sich um die üblichen, zur Verhinderung einer thermischen Polymerisation verwendeten Verbindungen, z. B. vom Typ des Hydrochinons, der Hydrochinonmonoalkylether, des 2,6-Di-t-butylphenols, der N-Nitrosoamine, der Phenothiazine oder Phosphorigsäureester.

Insbesondere für den Fall der lösungsmittelfreien Reaktionsführung kann das bei Raumtemperatur hochviskose bzw. feste Produkt vor dem Abkühlen verdünnt werden. Neben den bisher erwähnten Lösungsmitteln sind nach der Reaktion auch alkoholische Verdünner wie Methanol, Ethanol, Isopropanol, etc. geeignet.

Bezüglich der Aufbaukomponenten für die Herstellung der Umsetzungsprodukte (a) und für ihren Einsatz in den erfindungsgemäßen strahlungsempfindlichen Gemischen ist im einzelnen folgendes auszuführen.

Für die Umsetzung der Komponenten i) bis iv) kommen in Frage als ein-oder mehrfach ethylenisch ungesättigte Mono- oder Polyalkohole (i), vorzugsweise Hydroxygruppen enthaltende $\alpha,\beta$-ungesättigte Carbonylverbindungen, Allylalkohole, hydroxyfunktionalisierte Allylether und -ester und Hydroxyalkyl-Vinylether; besonders bevorzugt sind Hydroxyalkylacrylate und -methacrylate mit 2 bis 4 Kohlenstoffatomen in der Alkylgruppe, wobei die Alkylgruppen linear oder verzweigt sein können und ggf. noch weitere Substituenten tragen können, wie z. B. Hydroxyethylacrylat, Hydroxyethylmethacrylat, Hydroxypropylacrylat, Hydroxypropylmethacrylat, Butandiolmonoacrylat und Butandiolmonomethacrylat.

Als Isocyanatkomponente ii) sind alle Verbindungen geeignet, die mindestens zwei zur Reaktion mit Alkoholen oder primären bzw. sekundären Aminen befähigte Isocyanatgruppen enthalten. Besonders bevorzugt werden Diisocyanato-diphenylmethan, Diisocyanatotoluol (= Toluylendiisocyanat), Hexamethylendiisocyanat und Isophorondiisocyanat, sowie deren Oligomere vom Isocyanurat- und Biuret-Typ.

Als Aminoverbindung iii) sind alle primären und sekundären Amine geeignet, die gegenüber Isocyanatgruppen reaktiv sind. Beispiele sind n-Butylamin, n-Pentylamin, n-Hexylamin, Dodecylamin, Benzylamin, Ethylhexylamin, Dibutylamin, Ethylisopropylamin, 1-Methoxy-2-aminopropan, Dibenzylamin, 1,5-Dimethylhexylamin, Dipentylamin, Dihexylamin, Cyclopropylamin, Cyclopentylamin, Methylbenzylamin.

Besonders geeignet sind Amine der allgemeinen Formel

$R'HN-R-XH$

und/oder

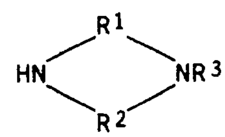 ,

wobei in der allgemeinen Formel

$R'HN-R-XH$

R für den zweiwertigen Rest eines, gegebenenfalls substituierten, Alkans, beispielsweise mit 2 bis 10 Kohlenstoffatomen, wie $-(CH_2)_p-$mit p = 2 bis 10, $-CH_2-C(CH_3)_2-CH_2-$ oder $-CH(CH_3)-CH_2-$, eines Arens, beispielsweise Phenylen, eines substituierten Arens, beispielsweise $-(CH_2)_r-C_6H_3(OH)-$ mit r = 1 bis 6, vorzugsweise 2, eines Ethers, beispielsweise $-(CH_2-CHR^{IV}-O)_q-CH_2-CHR^{IV}-$ mit q = 1 bis 5, und $R^{IV}$ = H oder Alkyl mit 1 bis 4 Kohlenstoffatomen, eines Amins, beispielsweise mit 2 bis 20 Kohlenstoffatomen, wie z. B. $-(CH_2)_3-N(CH_3)-(CH_2)_3-$, eines Polyamins, beispielsweise $-(CH_2-CH_2-NH)_o-$ mit o = 2 bis 5, eines Esters, beispielsweise mit 4 bis 20 Kohlenstoffatomen, wie z. B. $-(CH_2)_2-COO-(CH_2)_s-$ mit s = 2 bis 6, $-CH_2-COO-CH_2-CH(CH_3)-$, oder eines Amids, beispielsweise mit 4 bis 20 Kohlenstoffatomen, wie z. B $-(CH_2)_2-CONH-CH_2-$ oder $-(CH_2)_2-CONH-(CH_2)_5-NHOC-(CH_2)_2-$,;

R' für Wasserstoff, Alkyl, beispielsweise mit 1 bis 30, vorzugsweise 1 bis 10 Kohlenstoffatomen, wie z. B. Methyl, Ethyl, Propyl, Butyl sowie Isomere davon, Cyclohexyl, Aryl, beispielsweise mit 6 bis 18 Kohlenstoffatomen, vorzugsweise Phenyl, Naphthyl,

Aralkyl, beispielsweise mit 7 bis 20 Kohlenstoffatomen, z. B. Benzyl, 1-Methyl-3-phenylpropyl, 1-Phenylethyl,

Hydroxyalkyl, beispielsweise mit 2 bis 10 Kohlenstoffatomen, wie z. B. Hydroxyethyl, Hydroxypropyl, Hydroxybutyl,

Aminoalkyl, beispielsweise mit 2 bis 10 Kohlenstoffatomen, wie z. B. Aminoethyl, Aminopropyl, Dimethylaminobutyl, Dimethylaminoneopentyl, Mercaptoalkyl, beispielsweise mit 2 bis 10 Kohlenstoffatomen, wie z. B. Mercaptoethyl oder Derivate dieser Gruppen, wie z.B. Alkyl-, Aryl-, Halogen-, Carboxyl-, Nitro-, Nitril-, Sulfoxyl-, Amino-, Alkoxy-, Aryloxy-substituierte Derivate, oder den einwertigen Rest $H[O-(CH_2)_n-CHR'']_m$ mit n = 1 bis 3 und m = 1 bis 10 oder Isomere dieses Rests und $R''$ = H oder $C_1$- bis $C_4$-Alkyl, wie er durch einfache Addition bzw. Polyaddition von cyclischen Ethern, z. B. Ethylenoxid, Propylenoxid oder Tetrahydrofuran erhältlich ist, z. B. Hydroxyethyloxyethyl;

X für O, S oder $NR'''$, worin $R'''$ für Wasserstoff, Alkyl, beispielsweise mit 1 bis 10 Kohlenstoffatomen, wie z.B. Methyl oder Ethyl, Aryl, beispielsweise Phenyl oder Naphthyl, Aralkyl, beispielsweise Benzyl oder Phenylethyl, Hydroxyalkyl, Aminoalkyl oder Mercaptoalkyl, wobei deren Alkylgruppen jeweils 1 bis 10 Kohlenstoffatome enthalten können, oder Derivate dieser Gruppen der unter $R'$ genannten Art steht.

Beispiele für Verbindungen der allgemeinen Formel $R'$ HN-R-XH sind Ethylendiamin, Butandiamin, Neopentandiamin, Polyoxypropylendiamine, Polyoxyethylendiamine, N-Ethylethylendiamin, Diethylentriamin, Monoisopropanolamin. Besonders bevorzugt werden Ethanolamin, Diethanolamin, Diisopropanolamin, Neopentanolamin, Ethylisopropanolamin, Butylethanolamin und 2-Mercaptoethylamin.

In der allgemeinen Formel

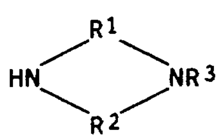 ,

können $R^1$ und $R^2$ untereinander gleich oder verschieden sein und insbesondere den zweiwertigen Rest eines, gegebenenfalls substituierten, Alkans, beispielsweise mit 2 bis 4 Kohlenstoffatomen, z. B. $-(CH_2)_t-$ mit t = 1 bis 4, Arens, beispielsweise o-Phenylen, Ethers, beispielsweise mit 2 bis 4 Kohlenstoffatomen, z. B. $-CH_2-O-CH_2-$bedeuten;

$R^3$ kann für Wasserstoff, Alkyl, Aryl, Aralkyl, Hydroxyalkyl, Aminoalkyl, Mercaptoalkyl oder deren Derivate der unter $R'$ genannten Art stehen. Bevorzugte Verbindungen der allgemeinen Formel

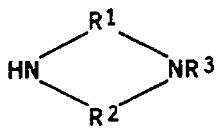 ,

sind Piperazin und 1-(2-Hydroxyethyl)piperazin.

Desgleichen eignen sich auch Gemische der unter iii) genannten Aminoverbindungen.

Als gegebenenfalls mitzuverwendende von Komponente i) verschiedene organische Verbindung mit mindestens einer Hydroxylgruppe iv) kommen gesättigte Mono- oder Polyalkohole in Frage. Bevorzugt werden aliphatische Alkohole, besonders bevorzugt aliphatische Monoalkohole wie z.B. Methanol, Ethanol oder Isopropanol.

(b) Als organische Verbindungen, die eine oder mehrere Carboxylgruppen enthalten, kommen niedermolekulare Carbonsäuren in Frage wie z.B. Monocarbonsäuren mit 1 bis 20 Kohlenstoffatomen oder Dicarbonsäuren, wie z.B. Adipinsäure, Phthalsäure, Terephthalsäure, Malonsäure, Bernsteinsäure, Fumarsäure oder Maleinsäure. Besonders geeignet als Komponente (b) sind carboxylgruppenhaltige Verbindungen, die aufgrund ihrer Zusammensetzung und ihres Molekulargewichts über gute Filmbildungseigenschaften verfügen. Bevorzugt werden Polymere mit einem mittleren Molekulargewicht $\overline{M}_n$ über 10.000, insbesondere zwischen 15.000 und 300.000 und einer Säurezahl, die zwischen 50 und 300 mg KOH/g liegt. Besonders bevorzugt sind Copolymere aus einem sauren Monomer wie z.B. Acrylsäure, Methacrylsäure, Crotonsäure oder Itaconsäure und einem oder mehreren hydrophoben Comonomeren, z.B. Styrol, Ethylacrylat, Butylacrylat, 2-Ethylhexylacrylat oder Methylmethacrylat. Besonders geeignet sind auch Styrol-Maleinsäureanhydrid-Copolymere, die mit niederen Alkoholen teilweise verestert sind. Die Zusammensetzung dieser Copolymeren wird zweckmäßigerweise so gewählt, daß sie mit der Komponente (a) verträglich sind.

Das Verhältnis von Komponente (b) zu Komponente (a) wird so gewählt, daß die erfindungsgemäßen strahlungsempfindlichen Gemische in der verwendeten Entwicklerlösung unlöslich sind, jedoch bei Bestrahlung löslich werden. Der Konzentrationsbereich, in dem dies erreicht wird, hängt von der zusammensetzung der Komponente (b) ab. Im allgemeinen hat sich für die Komponente (b) eine Konzentration von 5 bis 40 Gew.-%, besonders bevorzugt von 10 bis 30 Gew.-%, bezogen auf das Gesamtgewicht des strahlungsempfindlichen Gemisches, als günstig erwiesen.

(c) Als gegebenenfalls mitzuverwendende Photoinitiatoren für das erfindungsgemäße strahlungsempfindliche Gemisch kommen die für lichtempfindliche, photopolymerisierbare Aufzeichnungsmaterialien üblichen und an sich bekannten Photoinitiatoren bzw. Photoinitiatorsysteme in Betracht. Beispielhaft seien hierfür genannt: Benzoin, Benzoinether, insbesondere Benzoinalkylether, substituierte Benzoine, Alkylether von substituierten Benzoinen, wie z. B. $\alpha$-Methylbenzoinalkylether oder $\alpha$-Hydroxymethylbenzoinalkylether; Benzile, Benzilketale, insbesondere Benzildimethylketal, Benzilmethylethylketal oder Benzilmethylbenzylketal; die als Photoinitiator bekannten und wirksamen

Acylphosphinoxid-Verbindungen, wie z.B. 2,4,6-Trimethylbenzoyldiarylphosphinoxid; Benzophenon, Derivate des Benzophenons, 4,4′-Dimethylaminobenzophenon, Derivate von Michler's Keton; Anthrachinon und substituierte Anthrachinone; arylsubstituierte Imidazole oder deren Derivate, wie z. B. 2,4,5-Triarylimidazoldimere; Thioxanthonderivate, die als Photoinitiatoren wirksamen Acridin- oder Phenacin-Derivate und N-Alkoxypyridiniumsalze und deren Derivate. Geeignete Photoinitiatoren sind auch Diazoniumsalze, wie z. B. p-Phenylaminobenzoldiazoniumhexafluorophosphat, Iodoniumsalze, wie z. B. Diphenyliodonium-tetrafluoroborat, oder Sulfoniumsalze, wie z. B. Triphenylsulfonium-hexafluoroarsenat. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michler's Keton; oder Gemische aus 2,4,5-Triarylimidazol-Dimeren und Michler's Keton oder den Leukobasen von Triphenylmethanfarbstoffen. Die Auswahl der geeigneten Photoinitiatoren bzw. Photoinitiator-Systeme ist dem Fachmann geläufig. Besonders bevorzugte Photoinitiatoren sind Michlers Keton, Benzophenon, Hexaarylbisimidazol-Derivate und N-Alkoxypyridinium-Salze. Auch Mischungen der genannten Photoinitiatoren eignen sich sehr gut. Die Photoinitiatoren bzw. Photoinitiatorsysteme sind in der lichtempfindlichen Aufzeichnungsschicht im allgemeinen in Mengen von 0,1 bis 10 Gew.%, bezogen auf das strahlungsempfindliche Gemisch, enthalten.

(d) Als weitere Zusatz- und/oder Hilfsstoffe (d), die in dem erfindungsgemäßen strahlungsempfindlichen Gemisch enthalten sein können, kommen z. B. Farbstoffe und/oder Pigmente, photochrome Verbindungen bzw. Systeme, sensitometrische Regler, Weichmacher, Verlaufshilfsmittel, Mattierungs- oder Gleitmittel oder basische Komponenten und dergleichen in Betracht. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau 80 (C.I. 42 595), Viktoria-Blau B (C.I. 44 045), Rhodamin 6 G (C.I. 45 160), Triphenylmethanfarbstoffe,Naphthalimidfarbstoffe und 3′-Phenyl-7-dimethylamino-2,2′-spiro-di-(2H-1-benzopyran). Photochrome oder Farbumschlag-Systeme, die bei Belichtung mit aktinischem Licht reversibel oder irreversibel ihre Farbe ändern, ohne hierbei den Photopolymerisationsprozeß zu stören, sind z. B. Leukofarbstoffe zusammen mit geeigneten Aktivatoren. Als Beispiele für Leukofarbstoffe seien die Leukobasen der Triphenylmethanfarbstoffe, wie Kristallviolett-Leukobase und Malachitgrün-Leukobase, Leuko-Basischblau, Leuko-Pararosanilin, Leuko-Patentblau A oder V genannt; ferner kommt auch Rhodamin B-Base in Betracht. Als Aktivatoren für diese photochromen Verbindungen kommen u.a. organische Halogenverbindungen, die bei Belich tung mit aktinischem Licht Halogenradikale abspalten, oder Hexaarylbisimidazole in Betracht. Geeignete Farbumschlagsysteme sind auch in DE-A-38 24 551 beschrieben. Besonders geeignete Farbumschlagsysteme sind solche, bei denen die Farbintensität bei Belichtung geringer wird, wie z. B. Sudanfarbstoffe, Polymethinfarbstoffe oder Azofarbstoffe in Kombination mit geeigneten Photoinitiatoren. Zu den sensitometrischen Reglern gehören Verbindungen wie z. B. 9-Nitroanthracen, 10,10′-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate, Toluolsulfonamid oder Tricresylphosphat, dienen. Als basische Komponenten kommen Zusätze von Aminen, insbesondere tertiären Aminen, z.B. Triethylamin oder Triethanolamin, oder Alkali- und Erdalkalihydroxide und -carbonate in Betracht. Die Zusatz- und/oder Hilfsstoffe sind im strahlungsempfindlichen Gemisch in den für diese Stoffe üblichen und bekannten wirksamen Mengen vorhanden. Ihre Menge sollte jedoch im allgemeinen 30 Gew.%, vorzugsweise 20 Gew.%, bezogen auf das strahlungsempfindliche Gemisch, nicht überschreiten.

Die erfindungsgemäßen strahlungsempfindlichen Gemische können als weitere Zusatzstoffe (d) eine oder mehrere ein- oder mehrfach ethylenisch ungesättigte Verbindungen enthalten. Für diesen Zweck besonders geeignete ethylenisch ungesättigte Verbindungen sind Acrylate und Methacrylate, wie z.B. Trimethylolpropantriacrylat, Tripropylenglykoldiacrylat, Butylacrylat oder Butylmethacrylat. Die ethylenisch ungesättigten Verbindungen können dem strahlungsempfindlichen Gemisch bevorzugt in einer Konzentration von 1 - 20 Gew.%, besonders bevorzugt in einer Konzentration von 3 - 10 Gew.%, bezogen auf das Gesamtgewicht des strahlungsempfindlichen Gemisches, zugesetzt werden. Einen Zusatz von ethylenisch ungesättigten Verbindungen wird man insbesondere dann wählen, wenn man nach einem ersten Belichtungsschritt und der Entfernung des belichteten Materials in einer Entwicklerlösung in einem zweiten, längeren Belichtungsschritt eine Vernetzung herbeiführen will, um so die mechanische Stabilität, z. B. bei Druckplatten, zu verbessern.

Eine Folie oder Beschichtung kann hergestellt werden, indem die oben beschriebenen Verbindungen in einem Lösemittel gelöst werden, und die erhaltene Lösung dann durch Gießen, ggf. mit Hilfe eines Rakels, Aufschleudern, Roller-Coating oder andere Auftragsverfahren auf einen permanenten oder temporären Träger aufgebracht wird.

Geeignete Lösemittel sind z. B. aromatische Kohlenwasserstoffe, niedermolekulare Ketone, Alkohole, Ether, Ester und Chlorkohlenwasserstoffe.

Als Träger für die erfindungsgemäßen lichtempfindlichen Beschichtungen kann praktisch jedes auf dem Drucksektor und bei der Herstellung von Leiterplatten für die Elektronikindustrie gebräuchliche Material eingesetzt werden. Eine wichtige Bedingung ist jedoch, daß der Träger inert ist, d.h. nicht mit dem zur Herstellung der Beschichtung verwendeten lichtempfindlichem Gemisch reagiert.

Solche Trägermaterialien sind z. B. Stahl, Aluminiumlegierungen, mechanisch, chemisch oder elektrochemisch aufgerauhtes Aluminium, Silicium, Polyester und andere Kunststoffe. Die Schichtdicke kann dabei in weiten Grenzen variieren. Sie wird z. B. bei der Verwendung des strahlungsempfindlichen Gemisches als Hochdruck- oder Tiefdruckplatte typischerweise zwischen 50 und 500 µm, bei der Verwendung als Photoresist für die Herstellung gedruckter Schaltungen zwischen 20 und 100 µm und bei der Verwendung als Photoresist zur Strukturierung von Halbleitermaterialien zwischen 0,3 und 5 mm betragen. Wird das erfindungsgemäße strahlungsempfindliche Gemisch als Offsetdruckplatte verwendet, wird man die Beschichtung so vornehmen, daß Trockenschichtgewichte von 0,5 - 5 g/qm erhalten werden.

Die erfindungsgemäßen strahlungsempfindlichen Gemische eignen sich in vorteilhafter Weise für die Herstellung von Drucktormen oder Resistmustern nach den hierfür an sich bekannten und üblichen Verfahren. Hierzu wird die lichtempfindliche Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein.

Nach der bildmäßigen Belichtung wird die Druckform bzw. das Resistmuster durch Auswaschen der belichteten Bereiche der Aufzeichnungsschicht mit Wasser oder vorzugsweise einer wäßrig-alkalisohen Entwicklerlösung entwickelt. Das Entwickeln kann durch Waschen, Sprühen, Reiben, Bürsten etc. erfolgen. Die erfindungsgemäßen Aufzeichnungselemente zeigen dabei einen großen Entwicklungsspielraum und eine sehr geringe Überwaschempfindlichkeit. Als Entwicklerlösungen kommen wäßrig-alkalische Lösungen in Betracht, die zur Einstellung des günstigsten pH-Wertes, im allgemeinen im Bereich von 8 bis 14, vorzugsweise im Bereich von etwa 9 bis 13, alkalisch reagierende Substanzen, wie z. B. Borax, Dinatriumhydrogenphosphat, Soda, Alkalihydroxide oder organische Basen, wie Di- oder Triethanolamin in Wasser gelöst, enthalten. Die wäßrig-alkalischen Entwicklerlösungen können auch Puffersalze, z. B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z. B. Natriumcarboxymethylcellulose, Polyvinylalkohol, Polynatriumacrylat und dergleichen, mitverwendet werden. Obwohl die erfindungsgemäßen Aufzeichnungselemente im allgemeinen mit Wasser bzw. wäßrig-alkalischen Entwicklerlösungen ausgewaschen werden, ist es selbstverständlich grundsätzlich möglich, wenn auch nicht erforderlich, daß die Entwicklerlösungen auch noch geringe Zusätze an wasserlöslichen organischen Lösungsmitteln, wie z. B. aliphatischen Alkoholen, Aceton oder Tetrahydrofuran, enthalten.

Die erfindungsgemäßen strahlungsempfindlichen Gemische können z. B. durch energiereiche Strahlung wie Elektronen- oder Röntgenstrahlung strukturiert werden, wobei sie sich durch eine sehr hohe Strahlungsempfindlichkeit auszeichnen. Bei dieser Verwendung kann man im allgemeinen auf den Zusatz eines eigenen Initiatorsystems verzichten. Will man die erfindungsgemäßen Gemische hingegen durch sichtbares oder UV-Licht strukturieren, wie es bei der Herstellung von Druckplatten und Photoresisten üblich ist, wird man geeignete Photoinitiatoren zusetzen, deren spektrale Empfindlichkeit auf die Emission der verwendeten Lichtquelle abgestimmt ist. Auch diese Gemische zeichnen sich durch eine für positiv arbeitende Systeme sehr hohe Lichtempfindlichkeit aus, die der Lichtempfindlichkeit handelsüblicher Negativsysteme vergleichbarer Schichtdicke entspricht. Diese hohe Lichtempfindlichkeit wird erreicht, ohne daß zusätzliche Verfahrensschritte z. B. die bei vielen anderen Positivsystemen notwendige thermische Nachbehandlung erforderlich wären. Auch die eingesetzten Entwicklerlösungen entsprechen den bei negativ arbeitenden Schichten eingesetzten, so daß vollkommene Kompatibilität der erfindungsgemäßen Aufzeichnungsschichten mit herkömmlichen Systemen besteht. Die erfindungsgemäßen strahlungsempfindlichen Aufzeichnungsschichten eignen sich gut für Mehrfachbelichtungen. Dadurch können bei vielen Anwendungen Verfahrensschritte eingespart werden. Mehrfachbelichtungen sind bei allen photopolymerisierbaren Systemen, aber auch bei vielen Positivsystemen aus prinzipiellen Gründen nicht möglich. Die erfindungsgemäßen strahlungsempfindlichen Gemische weisen weiter die interessante Eigenschaft auf, daß sie zwar bei kurzen Bestrahlungszeiten als Positivsysteme arbeiten, bei längeren Bestrahlungszeiten jedoch als vernetzbare Systeme angesehen werden können. Dieser Effekt kann, wie beschrieben, durch Zusatz ethylenisch ungesättigter, polymerisierbarer Verbindungen verstärkt werden. Diese Eigenschaft kann ausgenützt werden, um nach einem ersten, bildmäßigen Belichtungsschritt mit kurzer Belichtungszeit und nach Entfernung der belichteten Bereiche in einer Entwicklerlösung in einem zweiten, nicht notwendigerweise bildmäßigen Belichtungsschritt mit deutlich höherer Belichtungszeit eine Vernetzung auszulösen. Auf diese Weise können die mechanischen Eigenschaften, z. B. von Druckplatten, verbessert werden.

Die Erfindung wird durch die nachstehenden Beispiele näher erläutert.

Die in der Herstellvorschrift und in den Beispielen genannten Teile und Prozente sind, soweit nicht anders angegeben, Gewichtsteile bzw. Gewichtsprozente.

Herstellung der erfindungsgemäß einzusetzenden Umsetzungsprodukte

Herstellvorschrift

In eine Vorlage mit 444 g Isophorondiisocyanat (2 Mol), 218 g Methylethylketon, 0,1 g Dibutylzinndilaurat und 1,1 g Di-tertiär-Butyl-4-methylphenol werden innerhalb 20 Minuten bei 21 bis 22°C 232,2 g Hydroxyethylacrylat (2 mol) zugetropft. Nach 2 Stunden Reaktionszeit bei 50 bis 53°C beträgt der NCO-Gehalt 8,30 %. Danach wird unter Eiskühlung bei 16°C eine Lösung von 240 g Diisopropanolamin (1,8 mol) in 103 g Methylethylketon innerhalb von 15 Minuten zugetropft. Die Reaktion ist nach weiterem Rühren über ca. 2 Stunden bei 50°C beendet. Das 72,1 %ige Produkt hat eine Viskosität von 335 mPa•s (gemessen bei 23°C mit einem Kegel-Platte-Viskosimeter).

Beispiel 1

8,5 g des nach obiger Herstellvorschrift hergestellten Umsetzungsprodukts, 1,5 g eines Copolymeren aus Styrol (25 %), Methylmethacrylat (35 5) Butylacrylat (10 %) und Methacrylsäure (30 %) mit einem K-Wert nach H. Fikentscher von 41, 700 mg N-Methoxypicolinium-tosylat und 15 mg Michler's Keton wurden in 8 g Methylethylketon gelöst und so auf eine 23 µm starke Polyethylenterephthalatfolie gegossen, daß die photoempfindliche Schicht nach dem Trocknen eine Stärke von 40 µm aufwies. Die Schicht wurde zur Aufbewahrung mit einer 30 µm starken PE-Folie abgedeckt. Zur Prüfung wurde die PE-Folie abgezogen, der Verbund aus Polyethylenterephthalatfolie und photoempfindlicher Schicht mit der photoempfind lichen Schicht zum Kupfer auf ein kupferkaschiertes Leiterplattensubstrat laminiert und auf einem Riston®-PC-Printer mit 60 mJ/cm$^2$ belichtet. Nach dem Abziehen der Polyethylenterephthalatfolie wurde in einem Sprühwascher 150 Sekunden mit 1 %iger Sodalösung von 30°C entwickelt, wobei sich die belichteten Teile der lichtempfindlichen Schicht vollkommen entfernen ließen. Die unbelichteten Teile blieben unverändert.

Beispiel 2

Analog zu Beispiel 1 wurden 8 g des nach obiger Herstellvorschrift hergestellten Umsetzungsprodukts und 2 g eines Copolymeren aus Methylmethacrylat (57 %), Ethylacrylat (20 %) und Methacrylsäure (23 %) mit einem K-Wert nach H. Fikentscher von 44 in 8 g Methylethylketon mit 700 mg N-Methoxypicolinium-tosylat und 15 mg Michler's-Keton versetzt. Die erhaltene Lösung wurde wie in Beispiel 1 weiterverarbeitet. Nach Belichtung in einem Riston-PC-Printer mit 60 mJ/cm$^2$ ließen sich die belichteten Stellen in 120 Sekunden mit 1 %iger Sodalösung entfernen.

Beispiel 3

Wie in Beispiel 1 wurden 8,5 g des nach obiger Herstellvorschrift erhaltenen Umsetzungsprodukts und 1,5 g des in Beispiel 1 beschriebenen Copolymeren in 8 g Methylethylketon gelöst und mit 200 mg 2,2′-Bis-(o-chlorphenyl)-4,4′,5,5′-tetra-(p-methoxyphenyl)bisimidazolyl, das in 1 ml Methylenchlorid vorgelöst worden war, versetzt. Die erhaltene Lösung wurde wie in Beispiel 1 weiterverarbeitet. Nach Belichtung mit 150 mJ/cm$^2$ betrug die zur Entfernung der belichteten Stellen erforderliche Entwicklungszeit in 1 %iger Sodalösung 150 Sekunden.

## Ansprüche

1. Strahlungsempfindliches, positiv arbeitendes Gemisch, dadurch gekennzeichnet, daß es besteht

aus
(a) einem Harnstoff- und Urethangruppen enthaltenden ethylenisch ungesättigten Umsetzungsprodukt,
(b) mindestens einer eine oder mehrere Carboxylgruppen enthaltenden organischen Verbindung,
(c) gegebenenfalls einem Photoinititator oder Photoinitiatorsystem
sowie
(d) gegebenenfalls weiteren Zusatz- und Hilfsstoffen,
wobei als Komponente (a) ein Harnstoff- und Urethangruppen enthaltendes ethylenisch ungesättigtes Umsetzungsprodukt eingesetzt wird, das durch Umsetzung von
i) mindestens einem ein- oder mehrfach ethylenisch ungesättigten Mono- oder Polyalkohol mit
ii) mindestens einem Di- oder Polyisocyanat und
iii) mindestens einer Aminoverbindung mit primärer und/oder sekundärer Aminogruppe,
sowie gegebenenfalls
iv) mindestens einer von Komponente i) verschiedenen organischen Verbindung mit mindestens einer Hydroxylgruppe,
wobei die Anzahl der NCO-Gruppen in Komponente ii) kleiner oder gleich der Anzahl der damit reaktiven Gruppen in Komponente i), iii) und iv) ist, erhalten worden ist.

2. Strahlungsempfindliches Gemisch nach Anspruch 1, dadurch gekennzeichnet, daß als Komponente (a) ein Umsetzungsprodukt eingesetzt wird, zu dessen Herstellung als Komponente i) ein einfach ethylenisch ungesättigter Mono- oder Polyalkohol verwendet wurde.

3. Strahlungsempfindliches Gemisch nach Anspruch 1, dadurch gekennzeichnet, daß als Komponente (a) ein Umsetzungsprodukt eingesetzt wird, zu dessen Herstellung als Komponente i) ein ein- oder mehrfach ethylenisch ungesättigter Monoalkohol verwendet wurde.

4. Strahlungsempfindliches Gemisch nach Anspruch 1, dadurch gekennzeichnet, daß als Komponente (a) ein Umsetzungsprodukt eingesetzt wird, zu dessen Herstellung als Komponente i) ein einfach ethylenisch ungesättigter Monoalkohol verwendet wurde.

5. Strahlungsempfindliches Gemisch nach Anspruch 1, dadurch gekennzeichnet, daß als Komponente (a) ein Umsetzungsprodukt eingesetzt wird, zu dessen Herstellung als Komponente i) eine eine Hydroxylgruppe enthaltende $\alpha,\beta$-ethylenisch ungesättigte Carbonylverbindung verwendet wurde.

6. Strahlungsempfindliches Gemisch nach Anspruch 1, dadurch gekennzeichnet, daß als Komponente (a) ein Umsetzungsprodukt eingesetzt wird, zu dessen Herstellung als Kompoennte i) ein Monohydroxyalkylacrylat oder -methacrylat verwendet wurde.

7. Strahlungsempfindliches Gemisch nach einem der vorhergehenden Ansprüche, dadurch gekennzeichnet, daß als Komponente (a) ein Umsetzungsprodukt eingesetzt wird, zu dessen Herstellung als Komponente ii) ein Diisocyanat verwendet wurde.

8. Strahlungsempfindliches Gemisch nach einem der vorhergehenden Ansprüche, dadurch gekennzeichnet, daß als Komponente (a) ein Umsetzungsprodukt eingesetzt wird, zu dessen Herstellung als Komponente iii) mindestens eine Aminoverbindung der allgemeinen Formel
$R'HN-R-XH$,
wobei
R den zweiwertigen Rest eines, gegebenenfalls substituierten, Alkans, Arens, Ethers, Polyethers, Amins, Polyamins, Esters, Polyesters, Amids oder Polyamids,
$R'$ Wasserstoff, Alkyl, Aryl, Aralkyl, Hydroxyalkyl, Aminoalkyl, Mercaptoalkyl, Derivate derselben oder den einwertigen Rest $H\{O-(CH_2)_n-CHR''\}_m$ mit $n$ = 1 bis 3 und $m$ = 1 bis 10 oder Isomere desselben und $R''$ = H oder $C_1$- bis $C_4$-Alkyl,
X O, S oder $NR'''$,
$R'''$ Wasserstoff, Alkyl, Aryl, Aralkyl, Hydroxyalkyl, Aminoalkyl, Mercaptoalkyl oder Derivate derselben bedeuten, und/oder
mindestens einer Aminoverbindung der allgemeinen Formel

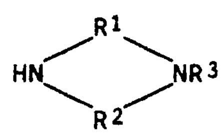 ,

wobei
$R^1$ und $R^2$ untereinander gleich oder verschieden sind und den zweiwertigen Rest eines, gegebenenfalls substituierten, Alkans, Arens, Ethers, Polyethers, Amins, Polyamins, Esters, Polyesters, Amids oder Polyamids bedeuten,
$R^3$ Wasserstoff, Alkyl, Aryl, Aralkyl, Hydroxyalkyl, Aminoalkyl, Mercaptoalkyl oder Derivate derselben bedeutet,
verwendet worden ist.

9. Strahlungsempfindliches Gemisch nach einem der vorhergehenden Ansprüche, dadurch gekennzeichnet, daß als Komponente (b) eine Carboxylgruppen enthaltende organische Verbindung mit einem mittleren Molekulargewicht $\overline{M}_n$ von mehr als 10.000 eingesetzt wird.

10. Strahlungsempfindliches Gemisch nach einem der vorhergehenden Ansprüche, dadurch gekennzeichnet, daß als Komponente (b) eine organische Verbindung mit einer Säurezahl zwischen 50 und 300 eingesetzt wird.

11. Strahlungsempfindliches Gemisch nach einem der vorhergehenden Ansprüche, dadurch gekennzeichnet, daß als Komponente (b) ein Copolymer

aus einem sauren Monomeren und mindestens einem hydrophoben Monomeren eingesetzt wird.

12. Strahlungsempfindliches Gemisch nach einem der vorhergehenden Ansprüche, dadurch gekennzeichnet, daß als saures Monomer Acrylsäure, Methacrylsäure, Crotonsäure und/oder Itaconsäure eingesetzt wird.

13. Strahlungsempfindliches Gemisch nach Anspruch 11 oder 12, dadurch gekennzeichnet, daß als hydrophobes Monomeres mindestens eines aus der Gruppe der Styrole, Acrylate und Methacrylate ausgewählt wird.

14. Strahlungsempfindliches Gemisch nach einem der vorhergehenden Ansprüche, dadurch gekennzeichnet, daß als Photoinitiator oder Photoinitiatorsystem Benzophenon oder seine Derivate, Hexaarylbisimidazolderivate, N-Alkoxypyridiniumsalze oder Gemische dieser Verbindungen eingesetzt werden.